# EUROPÄISCHE PATENTSCHRIFT

(11) **EP 0 618 305 B1**
(45) Veröffentlichungstag und Bekanntmachung des Hinweises auf die Patenterteilung: **12.07.1995**
(21) Anmeldenummer: 93118268.7
(22) Anmeldetag: 11.11.1993
(51) Int. Cl.: C23C 14/04, C23C 14/56

(54) **Verfahren und Vorrichtung zur Erzeugung von Mustern auf Substraten**
Process and device for creating patterns on substrates
Procédé de réalisation d'un motif sur un substrat et dispositif de mise en oeuvre

(30) Priorität: 27.03.1993 DE 4310085
(43) Veröffentlichungstag der Anmeldung: 05.10.1994
(73) Patentinhaber: LEYBOLD AKTIENGESELLSCHAFT, D-63450 Hanau (DE)
(72) Erfinder: Kleyer, Siegfried, Ing., D-63512 Hainburg (DE)

(56) Entgegenhaltungen:
- EP-A- 0 406 641
- DE-C- 4 100 643

## Beschreibung

Die Erfindung betrifft ein Verfahren und eine Vorrichtung zum Erzeugen von Mustern und Substraten unter stellenweiser Beschichtung der Substrate mit einem eine nachfolgende Beschichtung verhindernden Medium sowie durch nachfolgendes Aufbringen von mindestens einer Funktionsschicht.

Es ist ein Verfahren für die Metallisierung von Plastikfolien bekannt (US 4.832.983), bei dem die Folienbahn über eine rotierbare Walze aus Gummi geführt ist, deren zylindrische Umfangsfläche mit dem gewünschten Druckmuster versehen ist, wobei die einzelnen über die Umfangsfläche hervorstehenden Muster-Elememte einen Ölfilm an ihrer Oberfläche aufweisen, der beim Abrollen auf der Folienbahn die dem Muster entsprechenden Ölfilm-Abdrücke erzeugt. Die mit dem Öl-Muster versehene Folienbahn wird anschließend über eine gekühlte Walze geführt und dabei gleichzeitig bedampft, wobei sich der Metall-Dampf auf den ölfreien Partien der Folie niederschlägt.

Weiterhin ist ein Verfahren zur Metallisisierung einer zur Herstellung von elektrischen Kondensatoren dienenden Isolierstoffolie durch kontinuierliches Bedampfen im Durchlaufverfahren bekannt (DOS 2.234.510), bei dem die auf einer Rolle aufgewickelte, langgestreckte Folie kontinuierlich in einer evakuierten Anlage abgewickelt, in einer Bedampfungsstelle an einer den Metalldampf liefernden Quelle vorbeigeführt und dann in metallisiertem Zustand erneut aufgewickelt wird, wobei die von der Rolle abgewickelte Folie in vorgewärmtem Zustand in die Bedampfungsstelle eingeführt wird.

Darüberhinaus ist ein Verfahren zur Herstelung von metallfreien Streifen bei der Metallbedampfung eines Isolierstoffbandes bekannt (DE 3.224.234), das für den Einsatz in elektrischen Kondensatoren bestimmt ist, bei dem das Isolierstoffband im Bereich der herzustellenden metallfreien Streifen durch ein endloses, am Isolierstoffband anliegendes und mit gleicher Geschwindigkeit mit diesem mitlaufenden Abdeckband abgedeckt wird, das vor dem Einlaufen in die Bedampfungszone auf der dem Metallbedampfer zugewandten Seite mit Öl beschichtet wird und das nach dem Durchlaufen der Bedampfungszone und nach dem Auseinanderführen des Abdeckbandes und des Isolierstoffbandes vom aufgedampften Metall durch Abstreifen befreit wird, wobei zunächst das zu metallisierende Isolierstoffband und das Abdeckband zusammen in Kontakt gebracht werden, wobei dann durch Aufdampfen von Öl ein Film hergestellt wird, der auch die seitlichen Flächen des Abdeckbandes sowie geringfügig auch angrenzende Flächenbereiche des Isolierbandes bedeckt, wonach mit Metall bedampft wird.

Schließlich ist eine Vorrichtung zum Herstellen von metallfreien Streifen bekannt (DE 41 00 643), mit einem druckdicht verschließbaren Gehäuse, in dem eine Einrichtung zur Aufnahme und Weiterbewegung einer Folienbahn, insbesondere für Kondensatoren vorgesehen ist, sowie einer im Gehäuse angeordneten Verdampfungsquelle mit mindestens einer Düse für den Austritt des zu bedampfenden Mittels zur Verhinderung von Kondensation auf die vorbeilaufende Folienbahn, wobei die Düse aus mindestens einer sich in etwa über die gesamte Breite der Folienbahn erstreckenden Öffnung gebildet ist.

Die bekannten Verfahren und Vorrichtungen haben den Nachteil, daß entweder keine beliebigen bzw. frei wählbaren Muster auf den Folien mit Trennmittel markierbar sind oder aber die Gleichmäßigkeit des aufgebrachten Trennmittelfilms ungenügend ist, so daß die Partien auf denen sich Metall niedergeschlagen hat eine unscharfe Kontur aufweisen, wobei außerdem auch nicht gewährleistet ist, daß Trennmittel nicht zusätzlich Partien der Folienbahn benetzt, die mit Metall beschichtet werden sollen.

Der vorliegenden Erfindung liegt deshalb die Aufgabe zugrunde ein Verfahren und eine Vorrichtung zu schaffen, mit denen Kunststoffolien mit Partien mit beliebiger Konfiguration beschichtet werden können. Die metallisierten Partien sollen dabei eine hohe Konturenschärfe aufweisen, wobei die Gefahr, daß Benetzungsmittel auf die zu beschichtenden Partien kriecht oder sonstwie gelangt, gleichzeitig ausgeschlossen werden soll. Schließlich soll die Geschwindigkeit mit der die Folienbahn beschichtet wird in weiten Grenzen variierbar sein.

Erfindungsgemäß wird diese Aufgabe dadurch gelöst, daß man einen Musterträger nach Maßgabe des zu erzeugenden Musters mit einem Vertiefungsmuster versieht, bei dem die räumliche Verteilung der Vertiefungen den nicht zu beschichtenden Oberflächenbereichen des Substrats entspricht, daß man die Vertiefungen mit Dampf des die Beschichtung verhindernden Mediums füllt, das Substrat im wesentlichen sychron mit dem Musterträger bewegt, wobei die Vertiefungen mit ihren offenen Seiten auf die Substratoberfläche ausgerichtet sind, und dadurch den in Vertiefungen enthaltenen Dampf zur Kondesation auf dem Substrat bringt, und daß man schließlich nach dem Kondensieren mindestens einen Teil dieses Dampfes das Substrat mit mindestens einer Funktionsschicht versieht.

Die Merkmale der erfindungsgemäßen Vorrichtung sind in Anspruch 2 offenbart.

Weitere bevorzugte Merkmale und Einzelheiten der Vorrichtung sind in den abhängigen Patentansprüchen 3 bis 6 näher gekennzeichnet.

Die Erfindung läßt die verschiedensten Ausführungsmöglichkeiten zu; eine davon ist in den anhängenden Zeichnungen rein schematisch dargestellt, und zwar zeigen:
- Fig. 1: die Draufsicht auf einen Teil einer Bandbeschichtungsanlage, deren Wickelvorrichtung für den Ladevorgang aus der als Hohlzylinder ausgebildeten Beschichtungskammer herausgefahren ist, wobei einige der in Figur 2 dargestellten Umlenk- und Spannrollen der besseren Übersichtlichkeit wegen nicht näher dargestellt sind,
- Fig. 2: die Seitenansicht der Anlage, und zwar im Schnitt gemäß den Linien A - B nach Fig. 1,
- Fig. 3: einen Schnitt durch den Musterträger zum Benetzen der Folie mit Trennmittel, wobei der Musterträger in perspektivischer Ansicht dargestellt ist,
- Fig. 4: eine Seitenansicht des Trennmittelverdampfers und des Musterträgers gemäß Figur 1, jedoch in vergrößerter Darstellung und
- Fig. 5: eine Ausführungsvariante der Verdampferanordnung für eine Anlage bei der die Folienbahn den Musterträger nicht teilweise umschlingt, sondern an diesem in geringem Abstand vorbeigeführt ist.

Die Bandbeschichtungsanlage besteht im wesentlichen aus den zwischen zwei Platinen 3, 4 gelagerten Umlenk-, Zugmeß-, Streck- und Spannrollen 5 bis 9 bzw. 11 - 17, der gekühlten Beschichtungswalze 18, der Abwickelrolle 37', der Aufwickelrolle 35', dem Musterträger 10, der in der von einem Hohlzylinder 32 gebildeten Bechichtungskammer 28 angeordneten Verdampfungsquelle 19 mit Aluminiumdrahtspule 20 und dem Verdampferschiffchen 21 sowie einer Fernsehkamera 22 zur Beobachtung des Bechichtungsprozesses. Die beiden am Stützgestell 52 befestigten Platinen 3, 4 können über Rollen 26, 27 auf Laufschienen 24, 25, zusammen mit den Rollen 5 bis 9 bzw. 11 bis 17 und der Bechichtungswalze 18, die die Wickeleinrichtung bilden, in Pfeilrichtung R in die Beschichtungskammer 28 hinein bzw. aus dieser herausgefahren werden. Bei eingefahrener Wickeleinrichtung 29 legt sich der am Stützgestell 52 fest angeordnete scheibenförmige Deckel 30 mit seiner Randpartie gegen die flanschförmige Stirnfläche 31 des Hohlzylinders 32 und wird dort von nicht näher dargestellten Klammern am Hohlzylinder 32 fixiert bzw. durch den während der Betriebsphase in der Kammer 45 herrschenden Unterdruck vom Atmosphärendruck gegen die Stirnfläche 31 gezogen.

Das Verdampfergefäß 34 ist aus einem Hohlprofil gebildet, dessen beide Enden durch Endteile verschlossen sind. Im Inneren des Gefäßes 34 ist ein stabförmiges Heizelement angeordnet, das vom Trennmittel vollständig umspült ist. Das verdampfte Trennmittel tritt über eine Düsenleiste 36 in Richtung auf den Musterträger 10 aus. Eine Abstreifleiste oder Dichtleiste 47 trägt Sorge, daß das Trennmittel in den Vertiefungen 42, 42',... die das Druckmuster bilden und an der Zylindermantelfläche des Musterträgers 10 vorgesehen sind, verbleibt.

Im Übrigen ist das Verdampfergefäß 34 in einer Kammer 39 angeordnet, die einen Druck aufweist, der das Kondensieren des Trennmittels in diesem Bereich ausschließt, wobei die Kammer 39 einerseits von der Dichtleiste 47 und den Wandteilen 40, 41, 41' und andererseits von dem Musterträger 10 begrenzt ist.

Zweckmäßigerweise ist das Gefäß 34 noch mit einem Temperaturfühler ausgestattet, der eine genaue Überwachung und Einhaltung der Trennmitteltemperatur gestattet (der für die Überwachung und Regelung des Heizkreises notwendige Schaltkreis ist in der Zeichnung nicht näher dargestellt).

Das Verdampfergefäß 34 ist mit Hilfe von Winkelstücken 53, 53' zwischen den beiden Platinen 3, 4 gehalten, und zwar so, daß die Strahlrichtung der Düse 36 gegen die zu benetzende Fläche am Musterträger 10 ausgerichtet ist.

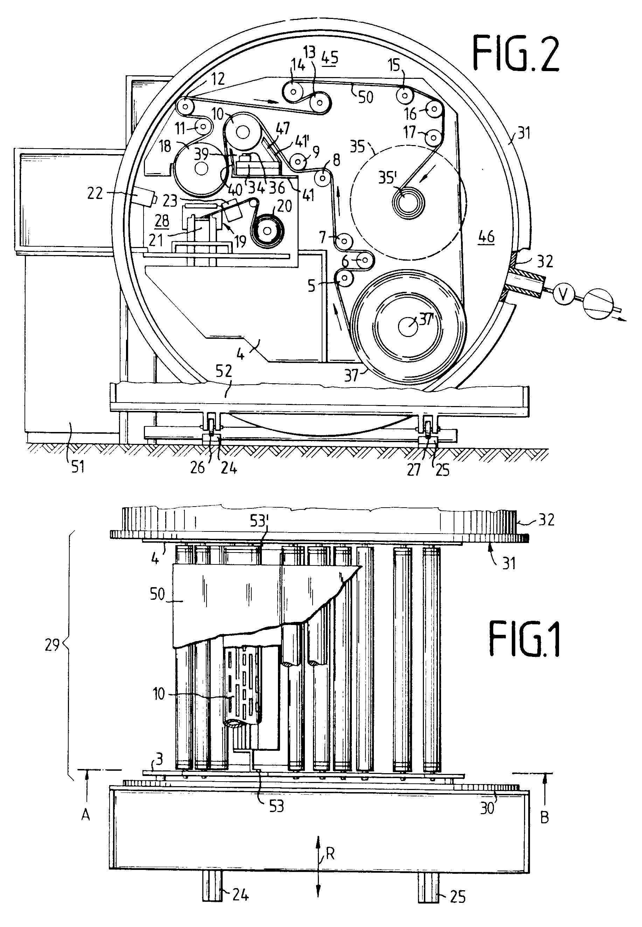

Wie Figur 1 zeigt, ist die Düse 36 an einem Abschnitt der Wickelbahn 50 angeordnet, der sich in unmittelbarer Nähe der Beschichtungswalze 18 befindet, so daß sofort nach dem Benetzen der durchlaufenden Folienbahn 50 mit Trennmittel der eigentliche Beschichtungsprozeß erfolgt. Es ist klar, daß sich auf den Partien der Folienbahn 50, die vom Trennmittel (beispielsweise einem Silikonöl) benetzt worden sind, das im Verdampfungsschiffchen 21 verdampfte Metall nicht niederschlagen kann, so daß es von der Zahl und Größe bzw. von der Kofiguration der Vertiefungen 42, 42',... am Musterträger 10 abhängt, welche Partien der Folienbahn 50 mit Metall unbedampft bzw. unbeschichtet bleiben.

Bei der in den Figuren 1 und 2 dargestellten Vorrichtung sind die Walzen 5 bis 9 zum Transport und zur Führung der Folienbahn 50 so angeordnet, daß die Partie der Folienbahn 50, die sich unmittelbar vor der Beschichtungswalze 18 befindet, in einem steilen Winkel, d. h. nahezu lotrecht vom Musterträger 10 aus nach unten läuft.

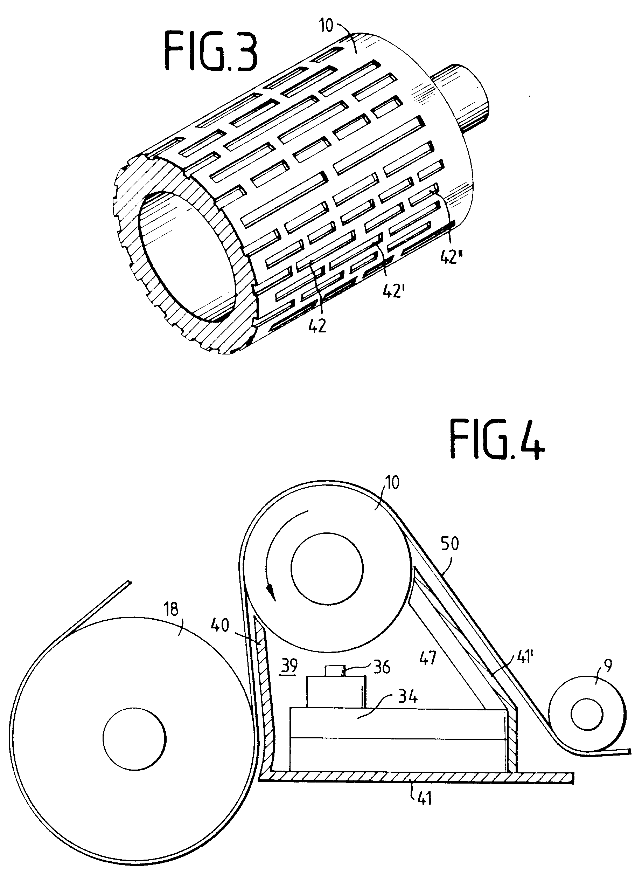

Es liegt auf der Hand, daß diese Partie der Folienbahn 50 auch anders geführt werden kann, beispielsweise in einer etwa horizontalen Ebene auf die Beschichtungswalze 18 auflaufen kann, ohne daß der in Figur 3 näher dargestellte Musterträger zum Auftragen des Netzmittels in seiner Lage und Größe geändert werden muß.

Wie Figur 3 zeigt, ist der Musterträger 10 als Hohlwalze ausgebildet, wobei die einzelnen Vertiefungen 42, 42', 42'',... ein Vertiefungsmuster ergeben. Der aus der Düsenleiste austretende Trennmitteldampf füllt den Raum 39 und damit auch die Vertiefungen 42, 42',... die nach dem Raum 39 zu geöffnet sind. Da der Musterträger 10 in Pfeilrichtung umläuft, verhindern der als Dichtleiste 47 ausgebildete Wandteil 41' bzw. die Wandteile 40, 41 das überschüssiger Dampf, d. h. nicht im Vertiefungsmuster gesammelter Dampf, in Richtung auf die Folienbahn 50 zu mitgenommen wird. Da anschließend der sich weiterdrehende Musterträger 10 mit der Folienbahn 50 in Kontakt gelangt bzw. sich auf dieser abwälzt, kondensiert der Trennmitteldampf auf der Folienbahn 50 und hinterläßt dabei das dem Vertiefungsmuster entsprechende Muster auf der Oberseite der Folienbahn 50.

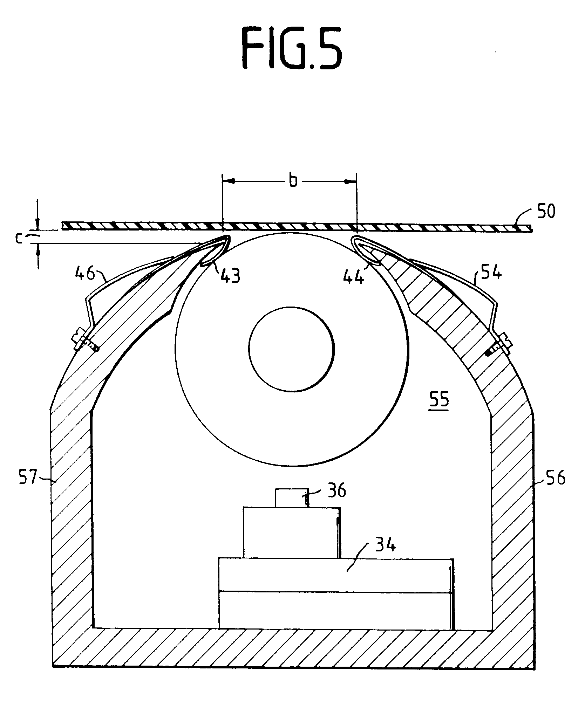

Figur 5 zeigt eine Ausführungsform einer Verdampferanordnung bei der die Folienbahn 50 den Musterträger 10 nicht umschlingt, sondern in unmittelbarer Nachbarschaft der Gehäuseöffnung b vorbeigeführt ist, wobei die Dichtleisten 43, 44 als federnde Profilbänder ausgebildet sind, die mit Hilfe der Blattfedern 46, 54 an den Musterträger 10 angedrückt werden, so daß nur das in den napfartigen Vertiefungen enthaltende Benetzungsmittel an die Folienbahn 50 abgegeben wird. Genau wie bei dem in Fig. 4 dargestellten Verdampfer weist auch in diesem Fall der Raum 55 zwischen den Dichtleisten 43, 44 und dem Verdampfergefäß 34 einen Überdruck gegenüber dem Raum oberhalb der Öffnung b auf.

### AUFLISTUNG DER EINZELTEILE

- 3: Platine
- 4: Platine
- 5: Umlenkrolle
- 6: Spannrolle
- 7: Umlenkrolle
- 8: Umlenkrolle
- 9: Breitstreckrolle
- 10: Druckwalze, Musterträger
- 11: Zugmeßrolle
- 12: Zugrolle
- 13: Meßwalze
- 14: Umlenkrolle
- 15: Breitstreckrolle
- 16: Zugmeßrolle
- 17: Umlenkrolle
- 18: gekühlte Beschichtungswalze
- 19: Verdampfungsquelle
- 20: Aluminiumdrahtspule
- 21: Verdampfungsschiffchen
- 22: Fernsehkamera
- 23: Drahtzuführung
- 24: Laufschiene
- 25: Laufschiene
- 26: Rolle
- 27: Rolle
- 28: Beschichtungskammer
- 29: Wickeleirichtung
- 30: Deckel
- 31: Stirnfläche
- 32: Hohlzylinder, Gehäuse
- 33: Trennmittel, Öl
- 34: Gefäß, Verdampfergefäß
- 35: Aufwickel
- 35': Aufwickelrolle
- 36: Düse, Düsenleiste
- 37: Abwickel
- 37': Abwickelrolle
- 39: Druckraum, Raum
- 40: Wandteil
- 41, 41': Wandteil
- 42, 42', 42'': Vertiefung
- 43: Dichtleiste
- 44: Dichtleiste
- 45: Kammer
- 46: Blattfeder
- 47: Abstreifleiste, Dichtleiste
- 50: Wickelbahn, Band, Folienbahn
- 51: Schaltschrank
- 52: Stützgestell
- 53: Winkelstück
- 53': Winkelstück
- 54: Blattfeder
- 55: abgeschlossener Raum
- 56: Wandteil
- 57: Wandteil

## Patentansprüche

1. Verfahren zum Erzeugen von Mustern auf Substraten (50) unter stellenweiser Beschichtung der Substrate (50) mit einem eine nachfolgende Beschichtung verhindernden Medium sowie durch nachfolgendes Aufbringen mindestens einer Funktionsschicht, **dadurch gekennzeichnet**, daß man einen Musterträger (10) nach Maßgabe des zu erzeugenden Musters mit einem Vertiefungsmuster versieht, bei dem die räumliche Verteilung der Vertiefungen (42, 42', 42'',...) den nicht zu beschichtenden Oberflächenbereichen des Substrats (50) entspricht, daß man die Vertiefungen (42, 42',42'',...) mit dem Dampf des die Beschichtung verhindernden Mediums füllt, das Substrat (50) im wesentlichen synchron mit dem Musterträger (10) bewegt, wobei der Musterträger (10) in Kontakt mit dem Substrat (50) gelangt und die Vertiefungen mit ihren offenen Seiten auf die Substratoberfläche ausgerichtet sind, und dadurch den in Vertiefungen enthaltenen Dampf zur Kondensation auf dem Substrat (50) bringt, und daß man schließlich nach dem Kondensieren mindestens eines Teils dieses Dampfes das Substrat (50) mit mindestens einer Funktionsschicht versieht.

2. Vorrichtung zum Herstellen von metallfreien Streifen bei im Vakuum beschichteten Folienbahnen (50), insbesondere für Kondensatoren, bestehend aus einem Gehäuse (32), mit einem Deckel (39) zum druckdichten Verschließen des Gehäuses und einer Wickeleinrichtung (29), mit drehbar gelagerten Umlenk- und Spannrollen (5 bis 9 bzw. 11 bis 17), mindestens einer Beschichtungsrolle (18) und einer Aufwickel- und Abwickelrolle (35', 37') sowie einer im Gehäuse (32) gehaltenen Beschichtungsquelle (19) und einem Gefäß (34) zur Aufnahme von einem Trennmittel, beispielsweise von einem Öl und mit mindestens einer Austrittsdüse (36) für den Austritt des zu verdampfenden Trennmittels aus dem Gefäß (34), **dadurch gekennzeichnet**, daß der Beschichtungsrolle (18) ein vorzugsweise als Druckwalze ausgebildeter Musterträger (10) mit einem Vertiefungsmuster (42) vorgeschaltet ist, wobei die Vertiefungen mit ihren offenen Seiten auf die Austrittsdüse (36) gerichtet sind und der Musterträger (10) synchron mit der Folienbahn (50) bewegbar ist und mit dieser in Kontakt tritt und mit einer Abstreif- oder Dichtleiste (47 bzw. 43, 44) die das verdampfte Trennmittel in dem Vertiefungsmuster (42) einschließen bzw. den überschüssigen Trennmitteldampf in einem Raum (39, 55) zurückhalten in dem der Verdampfer (34) angeordnet ist.

3. Vorrichtung nach Anspruch 2, **dadurch gekennzeichnet**, daß die Austrittsdüse (36) als Schlitz oder Lochreihe ausgebildet ist, wobei der aus dieser ausströmende Trennmitteldampf in einen Raum (39, 55) eintritt, der einerseits vom Musterträger (10) begrenzt ist und andererseits von Wandteilen (40, 41, 41', 56, 57) die gegenüber dem Musterträger (10) mit Hilfe von an diesem unmittelbar anliegenden oder aber einen engen Spalt mit diesem bildenden Dichtleisten oder Dichtlippen (47, 43, 44) abgedichtet sind, wobei der Raum (39, 55) einen gegenüber dem benachbarten Raum (45) erhöhten Druck aufweist.

4. Vorrichtung nach den Ansprüchen 2 und 3, **dadurch gekennzeichnet**, daß die Dichtleisten oder Dichtlippen (43, 44) mit Hilfe von elastischen Gliedern wie z.B. Federn (46, 54) oder mit Magneten gegen den Musterträger (10) gedrückt sind.

5. Vorrichtung nach den Ansprüchen 2 bis 4, **dadurch gekennzeichnet**, daß die Folienbahn (50) den als Walze ausgebildeten Musterträger (10) teilweise umschlingt.

6. Vorrichtung nach den Ansprüchen 2 bis 4, **dadurch gekennzeichnet**, daß die Folienbahn (50) an dem von den Dichtleisten (43, 44) begrenzten Spalt (b) in engem Abstand (c) zum Musterträger (10) vorbeigeführt wird.

## Claims

1. Method of producing patterns on substrates (50) by local coating of the substrates (50) with a resist medium and by the subsequent application of at least one functional layer, characterised in that a pattern support (10) is provided with a recessed pattern corresponding to the pattern to be produced, the spatial distribution of the recesses (42, 42', 42'', ...) corresponding to the surface areas of the substrate (50) not to be coated, in that the recesses (42, 42', 42'', ...) are filled with the vapour of a resist medium and the substrate (50) moves substantially synchronously with the pattern support (10), which comes into contact with the substrate (50) with the open sides of the recesses facing the substrate surface, thus causing the vapour contained in the recesses to condense against the substrate (50), and in that finally, when at least part of this vapour has condensed, the substrate (50) is provided with at least one functional layer.

2. Apparatus for producing metal-free stripes on vacuum-coated foil strips (50), in particular for capacitors, consisting of a housing (32), having a lid (39) for pressure-tight closure of the housing and a winding device (29) with rotatably mounted deflecting and tension rollers (5 to 9 or 11 to 17), at least one coating roller (18), and a winding and unwinding roller (35', 37'), as well as a coating source (19) held in the housing (32), and a vessel (34) for receiving a separating medium, e.g. an oil, and having at least one discharge nozzle (36) for discharging the separating medium to be vaporised from the vessel (34), characterised in that the coating roller (18) is connected upstream of a pattern support (10) with a recessed pattern (42), the open sides of the recesses being oriented towards the discharge nozzle (36) and the pattern support (10) being movable synchronously with the foil strip (50) and coming into contact therewith, and with a scraper or sealing strip (47 and 43, 44 respectively) which enclose the evaporated separating medium in the recessed pattern (42) or retain the surplus separating medium vapour in a chamber (39, 55) in which the evaporator (34) is disposed.

3. Apparatus according to claim 2, characterised in that the discharge nozzle (36) is formed as a slot or row of holes, and the separating medium vapour discharged therefrom enters a chamber (39, 55) defined on one side by the pattern support (10) and on the other side by wall members (40, 41, 41', 56, 57) which are sealed with respect to the pattern support (10) by means of sealing strips or sealing lips (47, 43, 44) directly abutting said pattern support or forming a narrow gap therewith, the chamber (39, 55) having a higher pressure than the adjacent chamber (45).

4. Apparatus according to claims 2 and 3, characterised in that the sealing strips or sealing lips (43, 44) are pressed against the pattern supports (10) by means of resilient members, e.g. springs (46, 54) or magnets.

5. Apparatus according to claims 2 to 4, characterised in that the foil strip (50) is partly wrapped round the pattern support (10) formed as a roller.

6. Apparatus according to claims 2 to 4, characterised in that the foil strip (50) is guided past the gap (b) defined by the sealing strips (43, 44) with narrow clearance (c) from the pattern support (10).

## Revendications

1. Procédé pour la production de dessins sur des substrats (50) par revêtement localisé des substrats (50) avec un agent empêchant un revêtement ultérieur, ainsi que par la déposition ultérieure d'au moins une couche fonctionnelle, caractérisé en ce que, selon les données du dessin à produire, on pourvoit un porte-dessins (10) d'un dessin en creux, dans lequel la répartition spatiale des creux (42, 42', 42'', ...) correspond aux régions de surface du substrat (50) qui ne sont pas à revêtir, en ce que l'on remplit les creux (42, 42', 42'', ...) avec la vapeur de l'agent empêchant le revêtement, en ce que l'on déplace le substrat (50) de façon sensiblement synchrone avec le porte-dessins (10), le porte-dessins (10) venant en contact avec le substrat (50) et les creux étant dirigés par leurs faces ouvertes vers la surface des substrats, et on amène ainsi la vapeur contenue dans les creux à se condenser sur le substrat (50), et en ce qu'après condensation d'au moins une partie de cette vapeur, on pourvoit finalement le substrat (50) d'au moins une couche fonctionnelle.

2. Dispositif pour la production de pistes exemptes de métal dans des bandes de film (50) revêtues sous vide, en particulier pour des condensateurs, constitué par un boîtier (32), comportant un couvercle (30) pour la fermeture étanche à la pression du boîtier et un dispositif de bobinage (29), comportant des rouleaux de renvoi et des rouleaux tendeurs (5 à 9 ou 11 à 17) montés en rotation, au moins un rouleau de revêtement (18) et un rouleau d'enroulement et de déroulement (35', 37'), ainsi qu'une source de revêtement (19) retenue dans le boîtier (32) et un récipient (34) pour la réception d'un agent séparateur, par exemple d'une huile, et comportant au moins une buse de sortie (36) pour la sortie de l'agent séparateur à vaporiser hors du récipient (34), caractérisé en ce que l'on prévoit avant le rouleau de revêtement (18) un porte-dessins (10), de préférence réalisé sous la forme d'un rouleau imprimeur, présentant un dessin en creux (42), les creux étant dirigés par leurs faces ouvertes vers la buse de sortie (36) et le porte-dessins (10) étant mobile de façon synchrone avec la bande de film (50) et venant en contact avec celle-ci, et comportant une barrette de raclage ou d'étanchéité (47 ou 43, 44) qui renferme l'agent séparateur vaporisé dans le dessin en creux (42) ou retient la vapeur d'agent séparateur superflue dans une chambre (39, 55) dans laquelle est agencé le vaporisateur (34).

3. Dispositif selon la revendication 2, caractérisé en ce que la buse de sortie (36) est réalisée sous la forme d'une fente ou d'une rangée de trous, la vapeur d'agent séparateur sortant de celle-ci entrant dans une chambre (39, 55) qui est délimitée d'une part par le porte-dessins (10) et d'autre part par des parties de paroi (40, 41, 41', 56, 57) qui sont étanchées par rapport au porte-dessins (10) à l'aide des barrettes d'étanchéité ou lèvres d'étanchéité (47, 43, 44) s'appuyant directement contre celui-ci ou formant une fente étroite avec celui-ci, la chambre (39, 55) présentant une pression élevée par rapport à la chambre voisine (45).

4. Dispositif selon les revendications 2 et 3, caractérisé en ce que les barrettes d'étanchéité ou lèvres d'étanchéité (43, 44) sont pressées contre le porte-dessins (10) à l'aide d'organes élastiques comme par exemple des ressorts (46, 54) ou à l'aide d'aimants.

5. Dispositif selon les revendications 2 à 4, caractérisé en ce que la bande de film (50) entoure partiellement le porte-dessins (10) réalisé sous la forme d'un rouleau.

6. Dispositif selon les revendications 2 à 4, caractérisé en ce que la bande de film (50) est guidée le long de la fente (b) délimitée par les barrettes d'étanchéité (43, 44) et à une distance faible (c) par rapport au porte-dessins (10).
